# EUROPEAN PATENT APPLICATION

(11) **EP 0 825 492 A1**
(43) Date of publication of application: **25.02.1998**
(21) Application number: 97306445.4
(22) Date of filing: 22.08.1997
(51) Int. Cl.: G03F 7/40, G03F 7/20

(54) **Method of treating a resist pattern on a semiconductor wafer**

(30) Priority: 23.08.1996 KR 3517196
(71) Applicant: Samsung Electronics Co., Ltd., Suwon City, Kyungki-do (KR)
(72) Inventor: Yeo, Gi-Sung, Kangnam-ku, Seoul (KR); Nam, Jeong-Lim, Paldal-ku, Suwan, Kyunggi-do (KR)
(74) Representative: Style, Kelda Camilla Karen

(57) **Abstract**

A more efficient method is disclosed which treats a resist pattern on a semiconductor wafer using a deep ultraviolet radiation so as to prevent the burning phenomenon of the resist pattern during patterning, and which comprises exposing the resist pattern formed on a semiconductor wafer to ultraviolet radiation sufficient enough to control an amount of resist thermal flow, and baking the resist pattern under a relatively high temperature to make the resist pattern be hardened. Even though a following etching process using the resist pattern as a mask is then performed under a very high temperature, the burning of the resist pattern can be prevented because the resist pattern is sufficiently exposed with deep ultraviolet radiation before baking the resist pattern.

## Description

The present invention relates to a method of forming a fine resist pattern, and in particularly, to a more efficient method of forming a resist pattern on a semiconductor wafer using deep ultraviolet radiation.

With the recent increase in integration degree of a semiconductor device, an etching technique with more high etch selectivity is required to obtain fine small contacts at deep steps. In this case, since a temperature in the etching chamber is very high, a serious problem is involved that in that burning of photoresist is frequently caused. Moreover, there is another problem in that etch selectivity should be lowered in the etching process, or the process conditions of the etching chamber should be seriously limited.

Accordingly, in order to solve such problems, a multilayer resist forming technique is proposed which comprises baking a bottom photoresist layer at the temperature of about 300°C, depositing an inter oxide layer over the bottom photoresist layer at the temperature lower than the baking temperature, forming a photoresist pattern on the inter oxide layer, and sequentially etching the inter oxide layer and the bottom photoresist layer using the photoresit layer as a mask. Also, such multilayer resist forming technique requires additionally forming a mask layer on a layer to be substantially etched, forming a pattern on the mask layer, selectively removing the mask layer to form a mask, ashing and striping a resist pattern, and etching an underlying layer using the mask layer. Since this technique is very complicated, productivity of semiconductor devices is reduced.

Alternatively, to prevent a wide resist pattern from remaining in a mask layout, the wide resist pattern should be exposed to a light beam in case of a positive process. Thus, partial steps are formed on a semiconductor device. This arises a new problem that DOF (depth of focus) margin is reduced in forming resist patterns. Furthermore, because of a photoresist layer which is located outside the device region on the wafer and not exposed to the light beam, an additional exposure process for the photoresist layer should be performed. This causes another problem that productivity of semiconductor devices is reduced.

It is an aim of embodiments of the present invention to try to solve these problems, and it is an aim of embodiments of the invention to provide a method of forming a resist pattern which is capable of preventing the burning thereof by means of deep ultraviolet radiation and baking, without an additional process.

According to an aspect of the present invention, a method of forming a resist pattern on a semiconductor wafer, comprises the steps of exposing the resist pattern to deep ultraviolet radiation sufficient enough to control an amount of resist thermal flow; and baking the resist pattern under a relatively high temperature to make the resist pattern be hardened.

In this embodiment, the resist pattern is comprised of a photoresist layer containing a deep ultraviolet absorbing agent. The deep ultraviolet radiation preferably has wavelength of about 248 nanometers. The step of baking the resist pattern is preferably performed at a temperature of about 165°C.

For a better understanding of the present invention and as to how the same may be carried into effect, reference will now be made by way of example to the accompanying Figures in which:
Figs. 1A through 1E are flow diagrams illustrating by sequential cross-sectional representation the process steps of a novel method of forming a resist pattern;
Figs. 2A through 2D are scanning electron micrographs showing cross-sectional views of the resist pattern after processing without and with deep ultraviolet radiation so as to explain that a thermal flow amount of the resist pattern is changed in accordance with intensity of the deep ultraviolet radiation; and
Figs. 3A through 3D are scanning electron micrographs showing top views of the resist pattern after processing without and with deep ultraviolet radiation so as to explain that the resist pattern is burnt out or normally formed during a baking process.

This invention will be illustrated hereinafter on the basis of an embodiment shown in accompanying drawings.

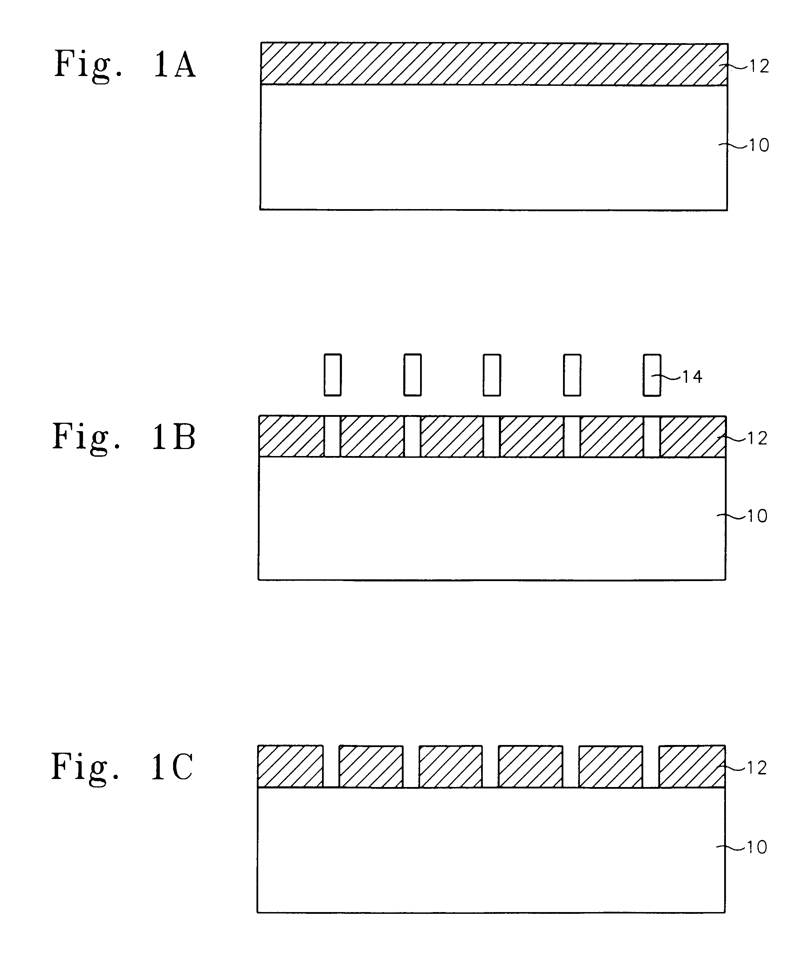

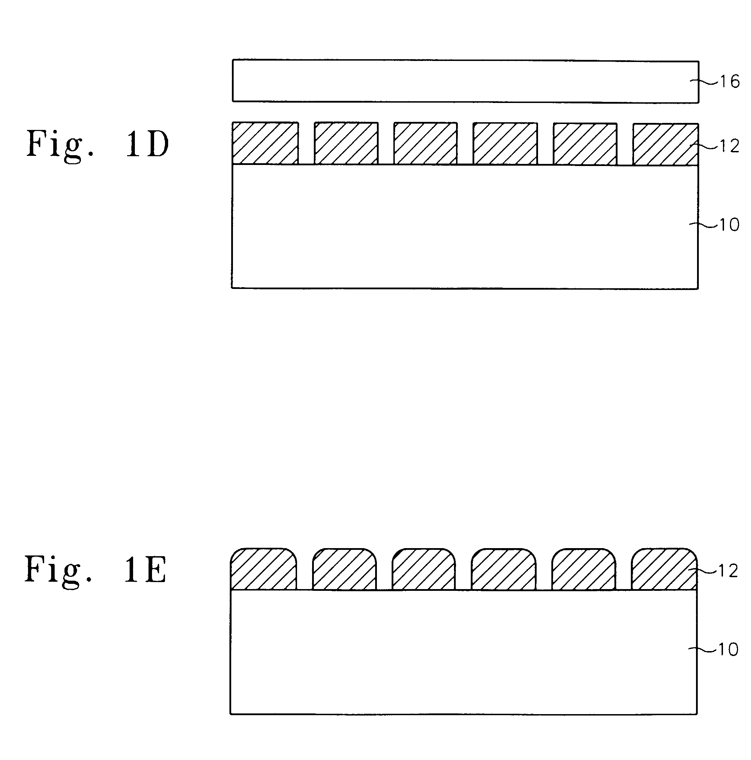

Referring to Figs. 1D and 1E, a novel method of forming a resist pattern embodying the invention comprises exposing, after forming a fine resist pattern on a semiconductor substrate, the resist pattern to deep ultraviolet radiation sufficient enough to control an amount of resist thermal flow and prevent the resist pattern from being burnt out during a following, for instance, etching process. Even though the etching process using the resist pattern as a mask is performed under a very high temperature, the resist pattern is not burnt out by sufficiently exposing it to deep ultraviolet radiation before baking it. Also, an accurately fine resist pattern can be obtained because a thermal flow amount of a resist pattern can be controlled in accordance with intensity of the deep ultraviolet radiation.

Hereinafter, the process steps of forming a resist pattern in accordance with an embodiment of the invention will be described with reference to accompanying drawings.

Referring to Figs. 1A to 1C, a photoresist layer 12 is deposited on a semiconductor substrate 10 and selectively exposed to deep ultraviolet beam 14 by a well-known phtolithography technique. As a result, a fine pattern is duplicated or transferred on the photoresist layer 12. So as to obtain an accurately fine pattern, the exposure having high resolution should be carried out using the G line or I line. Excimer laser lithography, phase shift technique, and the like may be used to form the fine pattern for a semiconductor device which is required to be finer in structure. Next, the semiconductor substrate 10 is subjected to a developing process to form the photoresist pattern 12 developed thus, as shown in Fig. 1C.

In this embodiment, the photoresist pattern is comprised of a photoresist layer containing a deep ultraviolet absorbing agent, i.e., a deep ultraviolet positive tone resist.

Subsequently, as shown in Fig. 1D, the photoresist pattern 12 is exposed to deep ultraviolet radiation 16 sufficiently enough to control a thermal flow amount thereof. This deep ultraviolet radiation 16 has wavelength of about 248 nanometers.

Finally, as shown in Fig. 1E, the semiconductor substrate 10 having the photoresist pattern 12 thereon is baked at the temperature of about 165°C, so that the photoresist pattern 12 is hardened. The semiconductor substrate 10 can be subjected directly to a high-temperature processing step, for example, a high-temperature annealing, a dry etching or the like. This is because the photoresist pattern 12 is sufficiently exposed using the deep ultraviolet radiation 16 and baked at a high temperature.

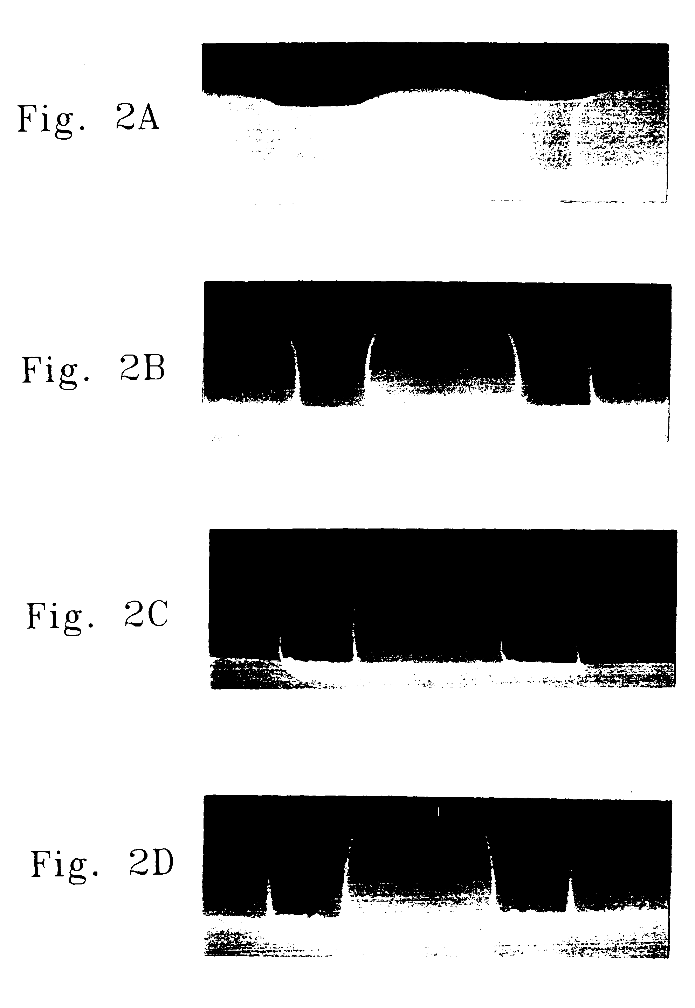

On the other hand, if a semiconductor substrate having a developed photoresist pattern thereon is subjected directly to a high-temperature baking process without the exposure of deep ultraviolet radiation, since the developed photoresist pattern is very poor in thermal stability, the deformation of pattern image is caused by thermal flow during the high-temperature baking process, as shown in Fig. 2A. As a result, it is difficult to form a photoresist pattern with high accuracy.

Accordingly, in order to solve such deformation of pattern image in the embodiment, a deep ultraviolet radiating process is performed in which a photoresist pattern on a semiconductor substrate is exposed to deep ultraviolet radiation prior to a high-temperature baking process, so that thermal flow amount thereof can be controlled. Also, with the deep ultraviolet radiation, the burning of the photoresist pattern can be prevented during a high-temperature processing step, for instance, a dry etching process, by which is followed.

Figs. 2A through 2D are scanning electron micrographs showing cross-sectional views of the photoresist pattern 12. From Fig. 2A, it can be seen that thermal flow amount of the photoresist pattern is very large when no ultraviolet radiation is applied to the photoresist pattern. It can be seen, however, from Figs. 2B to 2D that the thermal flow amount of the photoresist pattern is reduced in accordance with intensity of the ultraviolet radiation. When ultraviolet radiation of about 20mJ is applied to the photoresist pattern, as shown in Fig. 2B, the thermal flow amount of the pattern is somewhat reduced in comparison with the pattern shown in Fig. 2A. Also, when ultra violet radiation of about 60 mJ is applied, the thermal flow amount of the pattern is considerably reduced in comparison with the pattern shown in Fig. 2A. Accordingly, the thermal flow amount of a photoresist pattern is gradually reduced in accordance with intensity of deep ultraviolet radiation to be applied to the photoresist pattern, so that the photoresist pattern with more high accuracy can be obtained with high intensity of deep ultraviolet radiation.

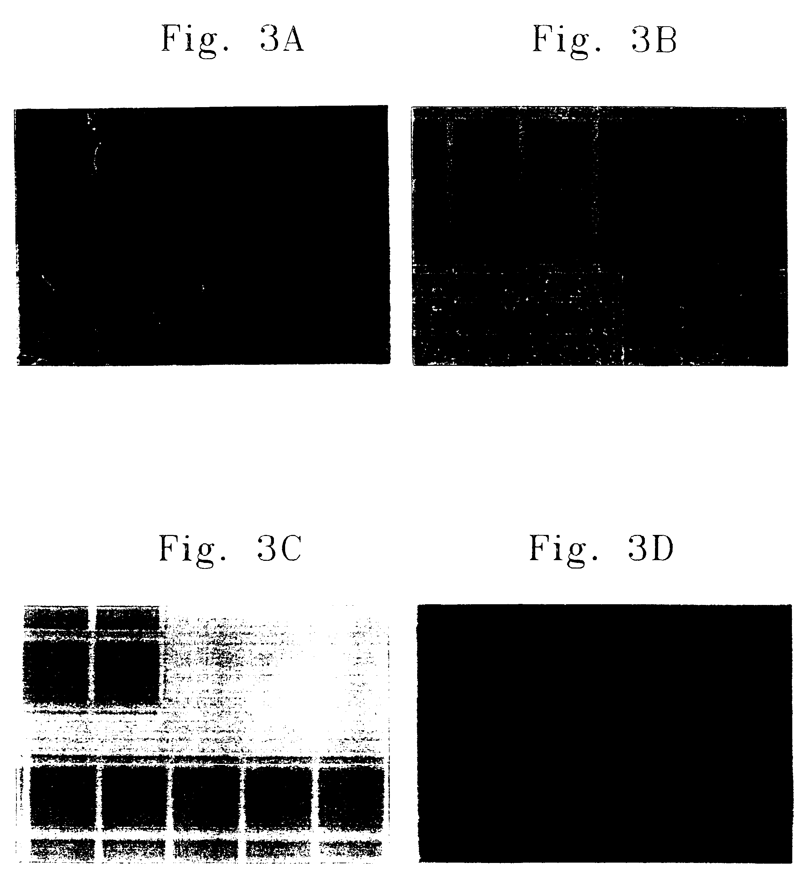

Figs. 3A through 3D are scanning electron micrographs showing top views of the photoresist patterns, which are etched after processing without and with deep ultraviolet radiation.

As can be seen from Figs. 3A, the serious burning of photoresist pattern is generated during an etching process in case that no ultraviolet radiation is applied to the photoresist pattern prior to the etching process. It can be seen, however, from Fig. 3B that the somewhat burning of photoresist pattern is generated during the etching process in case that split exposure of deep ultraviolet is applied to the photoresist pattern prior to the etching process.

In case that deep ultraviolet radiation of about 300 mJ is applied to the photoresist pattern, this pattern is not burnt out as shown in Fig. 3C. Also, in case that a photoresist pattern is exposed to deep ultraviolet radiation of about 300 mJ and subjected to a high-temperature baking process, no burning of the photoresist pattern is generated as shown in Fig. 3D.

As described above, according to a novel method embodying the invention, even though a high-temperature etching process is performed after deep ultraviolet radiation to a photoresist pattern, or after deep ultraviolet radiation and baking of a photoresist pattern, the burning of the photoresist pattern can be prevented because the photoresist pattern is sufficiently exposed with the deep ultraviolet radiation before the etching process.

## Claims

1. A method of forming a resist pattern on a semiconductor wafer, comprising the steps of:
exposing the resist pattern to deep ultraviolet radiation sufficient enough to control an amount of resist thermal flow; and
baking the resist pattern under a relatively high temperature to make the resist pattern be hardened.

2. The method according to claim 1, wherein said deep ultraviolet radiation is in the range of about 20 to 300 mJ.

3. The method according to claim 1 or 2, wherein said resist pattern is comprised of a photoresist layer containing a deep ultraviolet absorbing agent.

4. The method according to claim 1, 2 or 3, wherein said deep ultraviolet radiation has wavelength of about 248 nanometers and the resist pattern is baked at a temperature of about 165°C.

5. The method according to claim 1, 2 or 3, wherein the step of baking the resist pattern is performed at a temperature of about 300°C.
